# EUROPÄISCHE PATENTANMELDUNG

(11) **EP 1 195 820 A2**
(43) Veröffentlichungstag der Anmeldung: **10.04.2002**
(21) Anmeldenummer: 01120899.8
(22) Anmeldetag: 30.08.2001
(51) Int. Cl.: H01L 43/08

(54) **Integrierte magnetoresistive Schaltungsanordnung**

(30) Priorität: 06.09.2000 DE 10043947
(71) Anmelder: Infineon Technologies AG, 81669 München (DE)
(72) Erfinder: Bangert, Joachim, 91052 Erlangen (DE)
(74) Vertreter: Zimmermann & Partner

(57) **Zusammenfassung**

Integrierte Schaltungsanordnung mit mindestens einem Stromleiter, der im stromdurchflossenen Zustand ein Magnetfeld erzeugt, das auf wenigstens ein weiteres Teil der Schaltungsanordnung einwirkt, wobei zur Beeinflussung des erzeugbaren Magnetfelds der Stromleiter (2, 3, 16) querschnittlich gesehen wenigstens eine Ausnehmung (17) oder Eintiefung oder ein Bereich (22) niedrigerer Leitfähigkeit an der dem Teil zugewandten Seite aufweist.

## Beschreibung

Die Erfindung betrifft eine integrierte Schaltungsanordnung mit mindestens einem Stromleiter, der im stromdurchflossenen Zustand ein Magnetfeld erzeugt, das auf wenigstens ein weiteres Teil der Schaltungsanordnung einwirkt.

Derartige integrierte Schaltungsanordnungen sind beispielsweise in Form von Magnetokopplern oder Stromsensoren bekannt. Bei diesen ist ein Stromleiter vorgesehen, durch den ein Strom fließt. Bekanntermaßen erzeugt ein stromdurchflossener Leiter ein Magnetfeld, welches in der Schaltungsanordnung mittels des weiteren Teils, das dort als Messelement zur Messung des Magnetfelds ausgebildet ist, aufgenommen wird. Anhand der Größe des erhaltenen Messwerts kann die Größe des fließenden Stromes etc. erfasst werden.

Eine in jüngerer Zeit entwickelte integrierte Schaltungsanordnung ist die magnetische (random access memory) RAM-Speicherzelle (MRAM). Das MRAM dient zum Speichern großer Datenmengen und stellt eine Alternative zu üblichen Halbleiterspeichern dar. Bei einer solchen Schaltungsanordnung sind in zwei Ebenen angeordnete Stromleiter vorgesehen, die im Wesentlichen rechtwinklig zueinander verlaufen. An jedem Kreuzungspunkt ist ein zwischen den Stromleitern weiteres Teil in Form eines Schichtsystems vorgesehen, welches die eigentliche Speichereinheit bildet. Das Funktionsprinzip beruht darauf, dass innerhalb dieses Schichtsystems zwei magnetische Schichten vorgesehen sind, wobei die Magnetisierung einer Schicht (Referenzschicht) fest ist, während die Magnetisierung der zweiten Schicht (Speicherschicht) in Abhängigkeit eines externen Magnetfelds zwischen mindestens zwei Stellungen gedreht werden kann. Abhängig von der Stellung dieser Magnetisierung der Speicherschicht zur Magnetisierung der Referenzschicht ändert sich der durch dieses Schichtsystem fließende Strom. Denn die Magnetisierungsstellung ist ausschlaggebend für die Größe des Innenwiderstands der Anordnung.

Die Einstellung bzw. Änderung der Magnetisierung der Speicherschicht erfolgt dadurch, dass der jeweils untere und der jeweils obere, sich im Kreuzungspunkt, wo das zu beschreibende Schichtsystem ist, kreuzende Stromleiter mit dem zur Einstellung der Magnetisierung erforderlichen halben Strom beaufschlagt werden. Durch entsprechendes Timing der Beaufschlagungs- und Abschaltzeitpunkte des Stroms ist es möglich, ein auf die Magnetisierung wirkendes Magnetfeld hinreichender Stärke zu erzeugen, so dass die Magnetisierung eingestellt werden kann. Befindet sie sich bereits in der vom externen Feld vorgegebenen Richtung, so wird nichts geändert, steht sie in einer Richtung entgegengesetzt zur Magnetfeldrichtung, so klappt die Magnetisierung um. Nach Abschalten des externen Felds verbleibt die Magnetisierung in ihrer Ausrichtung.

Ein Problem aber ist, dass das von einem stromdurchflossenen Leiter erzeugte Magnetfeld stark inhomogen ist. Das Feld eines im Wesentlichen rechteckigen Leiters - da derartige integrierte Schaltungsanordnungen in dünnen Schichten aufgebaut sind, besitzt ein Leiter an der Grenzfläche zu einer nachfolgenden Schicht eine im Wesentlichen ebenen Fläche - ist im Wesentlichen glockenförmig, wobei das Magnetfeld zum Rand hin zwar abfällt, jedoch auch "verschmiert", also beachtlich breit ist. Das heißt, das weitere Teil, das in den meisten Anwendungen einer integrierten Schaltungsanordnung ein Messsystem ist, aber wie gesagt auch ein Speichersystem sein kann, sieht also unterschiedlich starke Feldbereiche. Dies bereitet insbesondere beim genannten MRAM Schwierigkeiten, da das Magnetfeld - in diesem Fall das aus der Überlagerung der beiden Magnetfelder des oberen und unteren Stromleiters resultierende Magnetfeld - zum Umschalten der gesamten Magnetisierung der Speicherschicht dienen soll, wobei diese eindomänig ist und ein Zerfall in mehrere Domänen vermieden werden muss. Ein Nachteil ist ferner darin zu sehen, dass bei einem etwaigen Misalignment, wenn also ein Speicherschicht- oder Messsystem nicht exakt unterhalb eines Stromleiters, sondern leicht versetzt dazu ist, aufgrund des Abfalls des Feldes ausgehend vom Kurvenmaximum ein Umschalten nicht unbedingt gewährleistet werden kann und der Zerfall in mehrere Domänen möglich ist.

Um ein homogeneres Magnetfeld zu erzeugen ist es denkbar, den Abstand zwischen Stromleiter und magnetischer Speicherschicht zu vergrößern, um zu erreichen, dass sich das Feld an der Speicherschicht verbreitert. Dies ist jedoch nicht praktikabel, da zum einen zur Erreichung der Schaltfeldstärken Ströme weit oberhalb der zulässigen Stromdichte erforderlich wären. Außerdem müsste ein zusätzlicher Kontakt zum Lesen der Informationen geschaffen werden. Schließlich müsste auch der Abstand der Speicherschichten vergrößert werden, um eine Beeinflussung benachbarter Speicherschichten zu vermeiden. Alternativ dazu ist es denkbar, die Stromleiter zu verbreitern, bis die Speicherschicht kleiner gegenüber der Stromleiterbahnbreite ist (Verhältnis z. B. 1:10). Dies ist jedoch ebenfalls nicht praktikabel, da dann die Packungsdichte nicht hinreichend groß gewählt werden kann, wobei eine sehr hohe Packungsdichte ein beachtlicher Vorteil eines MRAM gegenüber herkömmlichen Siliziumspeichern ist.

Der Erfindung liegt damit das Problem zugrunde eine Schaltungsanordnung anzugeben, die die Erzeugung eines homogeneren Magnetfelds ermöglicht.

Zur Lösung dieses Problems ist bei einer integrierten Schaltungsanordnung der eingangs genannten Art erfindungsgemäß vorgesehen, dass zur Beeinflussung des erzeugbaren Magnetfelds der Stromleiter querschnittlich gesehen wenigstens eine Ausnehmung oder Eintiefung oder ein Bereich niedrigerer Leitfähigkeit an der dem Teil zugewandten Seite aufweist.

Der Erfindung liegt die Erkenntnis zugrunde, dass das von einem stromdurchflossenen Leiter erzeugte Magnetfeld in seiner Form abhängig von der Leitergeometrie ist. Die Erfindung schlägt nun vor, die Geometrie des Leiterquerschnitts mittels der Ausnehmung oder der Eintiefung oder den nichtleitenden Bereich an der dem Teil zugeordneten Seite zu variieren, um so den Feldverlauf vornehmlich zur Homogenisierung zu beeinflussen. Gemäß der Erfindung ist vorgesehen, dass in einem bestimmten Bereich die effektive Leitergeometrie und damit den Bereich, innerhalb welcher der Stromtransport erfolgt, zu variieren. Hierdurch ist es möglich, das sich über der dem Teil zugewandten Leiterseite aufbauende Magnetfeld zu "designen", nämlich abhängig davon, wie die Leiterform bzw. -geometrie infolge der Ausnehmung etc. aussieht. Dies bietet die Möglichkeit, die sich bei der bekannten Glockenform des Felds über einer solchen flachen Seite ergebenden Bereich um das Kurvenmaximum quasi abzuflachen und einzuebnen, so dass das weitere Teil ein deutlich homogeneres Feld sieht. Gleichermaßen kann man auch einen umgekehrten Effekt zur Feldkonzentration erzielen, wenn zwei seitliche Ausnehmungen vorgesehen sind, so dass in der Mitte eine Erhöhung verbleibt. Als "Ausnehmung" oder "Eintiefung" oder "Bereich niedriger Leitfähigkeit" ist jede Oberflächenveränderung zu verstehen, die die idealerweise ebene Leiteroberfläche uneben macht bzw. ein unebenes Stromleitungsprofil verleiht. Mittels der Ausnehmung, der Eintiefung oder dem Bereich können Stufen aber auch gewölbte Formen geschaffen werden.

Die Erfindung ist gleichermaßen einsetzbar bei einer Schaltungsanordnung mit einem Stromleiter und einem weiteren zu diesem benachbarten Teil, wie beispielsweise bei einem Stromsensor oder einem Magnetokoppler vorgesehen. Daneben ist sie auch wie ausgeführt bei einer Schaltungsanordnung in Form eines MRAMs einsetzbar, bei der mehrere in zwei Ebenen liegende und sich im Wesentlichen rechtwinklig kreuzende Stromleiter vorgesehen sind, zwischen denen an jeweils einem Kreuzungspunkt ein weiteres Teil aufgenommen ist. Bei dieser Ausführungsform der Schaltungsanordnung kann nur einer der sich in einem Kreuzungspunkt kreuzenden Stromleiter eine Ausnehmung oder Eintiefung oder einen Bereich niedrigerer Leitfähigkeit aufweisen. Aus herstellungstechnischen Gründen ist es einfacher, die oberen, später erzeugten Stromleiter entsprechend auszubilden. Natürlich ist es auch möglich, beide sich in einem Kreuzungspunkt kreuzenden Stromleiter in ihrer effektiven Leitergeometrie bereichsweise zu variieren und so beide einzelnen Magnetfelder beeinflussen, insbesondere zu homogenisieren. Eine weitere mögliche Anwendung ist die magnetische Logik, deren Grundzellen ähnlich der MRAM-Speicherzelle oder dem Sensor ausgelegt werden sollen.

Erfindungsgemäß kann sich die Ausnehmung, die Eintiefung oder der Bereich über einen wesentlichen Teil der Länge des oder eines Stromleiters erstrecken. Alternativ hierzu kann die Geometrieänderung auch nur im Wesentlichen punktuell im Bereich der Kreuzungspunkte an dem oder beiden Stromleitern vorgesehen sein.

Gemäß der beschriebenen ersten Erfindungsalternative kann die geometrische Auslegung des Leiters dadurch erzeugt werden, dass an der Seite des Stromleiters, die dem weiteren Teil zugewandt ist, eine Ausnehmung oder eine Eintiefung vorgesehen ist. Bei dieser Ausführungsform wird also durch Änderung der Oberflächenstruktur bzw. der Form des Stromleiters die Dickenreduzierung erzielt. Dabei kann die Ausnehmung oder Eintiefung einen im Wesentlichen rechteckigen Querschnitt aufweisen, soweit dies bei den kleinen Strukturen, die im Bereich mehrerer Nanometer liegen, definiert möglich ist. In diesem Fall werden also näherungsweise drei Bereiche über die Leiterbreite erzeugt, nämlich die beiden Randbereiche größeren Durchmessers sowie der mittlere Bereich verringerten Durchmessers. Eine Alternative sieht demgegenüber vor, dass die Ausnehmung oder Eintiefung einen im Wesentlichen konkaven Querschnitt aufweist. Hier nimmt der Durchmesser ausgehend vom mittigen Minimum kontinuierlich zu den Rändern des Leiters hin zu, ausgehend von der Annahme eines idealen rechteckigen Leiters.

Die Ausnehmung oder Eintiefung ist zweckmäßigerweise mit einem nichtleitenden Material gefüllt, wobei dieses Material abhängig von der Art der Herstellung - worauf nachfolgend noch eingegangen wird - entweder aufgrund seiner Form zum Ausbilden der Eintiefung selbst dient, oder aber zum nachträglichen Auffüllen, um die Oberfläche zu homogenisieren.

Für die allgemeinste Auslegung wird als Material zweckmäßigerweise ein nichtleitender Lack verwendet. Dieser kann auf einfache Weise photolithographisch aufgebracht und geformt und verarbeitet werden. Diese Technik ist hinreichend handhabbar. Alternativ dazu besteht die Möglichkeit, ein vergleichsweise (zum Leitermaterial Kupfer oder Aluminium) hochohmiges Material, insbesondere die hochohmige Phase von Tantal zu verwenden. Weitere isolierende Materialien sind im Prozess verfügbar, wie z.B. Al₂O₃, SiOx, SiNx und Kombinationen davon. Für die Anwendung der MRAM-Speicherzelle kann für die Seite, auf der die Referenzschicht liegt, auch ein nichtleitender Magnetwerkstoff verwendet werden, der entweder in der Anordnung zur Verfügung steht oder - sinnvollerweise - die Eigenschaften der Referenzschicht unterstützt. Hier ist z.B. NiO als Antiferromagnet mit Dicken von ≥ ca. 10 nm sehr gut geeignet.

Neben der Ausbildung einer Ausnehmung oder Eintiefung ist es wie beschrieben gleichermaßen zweckmäßig, zur Verringerung der Leiterdicke an der dem Teil gegenüberstehenden Seite des Stromleiters einen Bereich niedrigerer Leitfähigkeit vorzusehen. Dieser Bereich niedriger Leitfähigkeit ist gleichermaßen wie der Bereich der Ausnehmung oder Eintiefung vom Stromtransport ausgeschlossen. Denn der Strom fließt im übrigen Leiterbereich, wo ein niedriger Widerstand bzw. eine höhere Leitfähigkeit gegeben ist. Dieser Bereich niedriger Leitfähigkeit bzw. der Bereich erhöhten Widerstands kann entweder durch Ionenbeschuss beispielsweise mittels Fe-Ionen oder durch Diffusion wenigstens eines Elements, beispielsweise Si erzeugt sein.

Im Bezug auf die im Idealfall gegebene exakte Überdeckung eines Stromleiters und eines weiteren Teils - insbesondere beim MRAM - ist es zweckmäßig, wenn der Bereich der Ausnehmung oder Eintiefung bzw. der Bereich niedrigerer Leitfähigkeit im Wesentlichen mittig am Stromleiter bezogen auf seine Breite vorgesehen ist.

Um neben der Homogenisierung des Magnetfelds auch ein möglichst schnelles Abfallen der Feldflanken (räumlich) zu ermöglichen, um die Breite des Feldes - das bereits aufgrund der vorbeschriebenen Dickenänderung etwas schmäler wird - zu verringern, ist es vorteilhaft, wenn an der gegenüberliegenden Seite des Stromleiters randseitig Ausnehmungen oder Eintiefungen oder Bereiche niedrigerer Leitfähigkeit zur Reduktion der Dicke vorgesehen sind, die neben dem ersten Abschnitt reduzierter Leiterdicke angeordnet sind, wobei dieser aber wie beschrieben an der gegenüberliegenden Seite ist. Die Herstellung kann gleichermaßen wie vorbeschrieben erfolgen, also durch "echte" Ausnehmungen durch Formänderung bzw. Strukturierung oder aber durch Erzeugen von Bereichen hohen Widerstands.

Neben der integrierten Schaltungsanordnung selbst betrifft die Erfindung ferner ein erstes Verfahren zur Herstellung einer integrierten Schaltungsanordnung mit einem oder mehreren in einer Ebene liegenden Stromleitern, bei welchem Verfahren nach Erzeugung des weiteren Teils in Form einer durch ein Magnetfeld beeinflussbaren Schicht, z. B. in Form eines Schichtsystems folgende Schritte durchgeführt werden:
- Erzeugen einer Schicht aus nichtleitendem Material entsprechend der Lage eines nachfolgend zu erzeugenden Stromleiters,
- Reduzieren der Dicke und/oder Breite der Materialschicht,
- Aufbringen eines die Materialschicht überdeckenden Stromleiters.

Bei dieser Verfahrensausgestaltung wird die Durchmesserreduzierung des Stromleiters durch vorheriges Erzeugen und Dimensionieren der Materialschicht erzielt, über welche dann das Stromleitermaterial geschichtet wird. Als Material kann ein Lack verwendet werden, der vor der Reduktion belichtet und entwickelt wird. Zur Reduktion selbst kann der Lack verascht werden, wobei zu betonen ist, dass ganz allgemein jede aus der Photolithographie bekannte Möglichkeit zur Lackentfernung bzw. Lackdicken- und -breitenverringerung verwendet werden kann.

Alternativ zur Verwendung des Lacks kann als Material auch ein nichtleitendes Metall, insbesondere die hochohmige Phase von Tantal verwendet werden, wobei in diesem Fall das Metall zur Reduktion geätzt wird oder andere, bekannte Möglichkeiten (z.B. Elektronenstrahlbeschichtung der kritischen Punkte oder andere direkte, hochertsauflösende Lithographieverfahren).

Eine zweite Verfahrensalternative zur Herstellung einer integrierten Schaltungsanordnung mit einem oder mehreren in einer Ebene liegenden Stromleiter sieht vor, dass vor der Erzeugung des weiteren Teils in Form einer durch ein Magnetfeld beeinflussbaren Schicht folgende Schritte durchgeführt werden:
- Erzeugen eines oder mehrerer Stromleiter auf einem Substrat,
- Erzeugen eines Bereichs niedrigerer Leitfähigkeit an der freien Seite eines Stromleiters zur Reduktion der für die Ausbildung eines Magnetfelds bei Stromfluss relevanten Leiterdicke,
   wonach die beeinflussbare Schicht auf einem Stromleiter erzeugt wird.

Bezogen auf die Herstellung eines MRAMs ermöglicht die vorher beschriebene Verfahrensvariante die Strukturierung des oberen, also zeitlich später abgeschiedenen Stromleiters, während die vorliegende Verfahrensvariante die Ausbildung des unteren, zuerst erzeugten Stromleiters im erfindungsgemäßen Sinn ermöglicht. Die Leitfähigkeitsänderung wird hier durch Ionenbeschuss, alternativ durch Diffusion wenigstens eines die Leitfähigkeit erniedrigenden Elements (oder Moleküls) in den Stromleiter erzeugt.

Im Falle der Ausbildung der verfahrensgemäß herzustellenden Schaltungsanordnung als Magnetokoppler oder Stromsensor oder dergleichen, wo also nur Stromleiter in einer Ebene vorkommen, ist die Ausbildung eines zweiten Stromleiters oder einer zweiten Stromleiterebene nicht erforderlich.

Für den Fall aber, dass ein MRAM mit in zwei Ebenen befindlichen Stromleitern hergestellt wird, muss im Falle der zweiten Verfahrensvariante eine zweite Stromleiterebene erzeugt werden, die nach Herstellen der veränderbaren oder beeinflussbaren Schicht erzeugt wird. Diese Stromleiter müssen nicht unbedingt im erfindungsgemäßen Sinn strukturiert sein. Es ist jedoch zweckmäßig, wenn die nach der Erzeugung der beeinflussbaren Schicht über dieser liegenden Stromleiter ebenfalls strukturiert werden, bevorzugt gemäß dem vorher beschriebenen Verfahren.

Eine weitere Verfahrensvariante zur erfindungsgemäßen Ausbildung eines unten liegenden, vergrabenen Stromleiters sieht vor der Erzeugung des weiteren Teils in Form einer durch ein Magnetfeld veränderbaren oder beeinflussbaren Schicht folgende Schritte vor:
- Erzeugen eines oder mehrerer Stromleiter auf einem Substrat,
- Erzeugen einer Ausnehmung oder Eintiefung an der freien Seite eines Stromleiters zur Reduktion der für die Ausbildung eines Magnetfelds bei Stromfluss relevanten Leiterdicke,
- Einbringen eines nichtleitenden Materials in die Ausnehmung oder Eintiefung, wonach die beeinflussbare Schicht auf einem Stromleiter erzeugt wird.

Bei dieser Ausgestaltung wird also in der Oberseite des erzeugten Stromleiters eine Ausnehmung oder Eintiefung zur Strukturierung bzw. Formgebung erzeugt, bevorzugt in einem Sputterverfahren, welche nachfolgend mit nichtleitendem Material gefüllt wird, um eine ebene Fläche für die nachfolgend aufwachsende veränderbare Schicht bzw. das Schichtsystem zu bilden. Als Material kann auch hier ein Lack, alternativ ein nichtleitendes Metall verwendet werden. Auch hier bietet sich an, im Falle eines MRAMs auch die nachfolgend erzeugten Stromleiter der zweiten Ebene entsprechend dem eingangs beschriebenen Verfahren zu strukturieren.

Schließlich ist ein drittes Verfahren zur Herstellung einer Schaltungsanordnung vorgesehen, bei welchem Verfahren vor der Erzeugung der beeinflussbaren Schicht folgende Schritte durchgeführt werden:
- Erzeugen eines oder mehrerer Stromleiter auf einem Substrat,
- Erzeugen einer Schicht aus nichtleitendem Material auf einem Stromleiter,
- Reduzieren der Dicke und/oder Breite der Materialschicht,
- Erzeugen weiterer die verbliebene reduzierte Materialschicht seitlich umgebender Abschnitte des Stromleiters zur Bildung eines Stromleiters mit einer für die Ausbildung eines Magnetfelds bei Stromfluss reduzierten relevanten Leiterdicke,
   wonach die beeinflussbare Schicht auf einem Stromleiter erzeugt wird.

Bei dieser Ausführung wird also der Stromleiter selbst in mehreren Schritten gebildet. Zunächst wird eine erste Stromleiterschicht abgeschieden, anschließend wird die nichtleitende Materialschicht aufgebracht und dimensioniert, wonach seitlich zwei weitere Stromleiterschichten abgeschieden werden, so dass sich auch hier Ausnehmungen oder Eintiefungen an den Stromleitern bilden. Auch hier kann wiederum ein Lack oder ein nichtleitendes Metall verwendet werden. Zweckmäßig ist auch hier die entsprechende Ausbildung der im Falle eines MRAMs nachfolgend herzustellenden Stromleiter der zweiten Ebene.

Weitere zweckmäßige Verfahrensalternativen sind den weiteren nebengeordneten Patentansprüchen und deren Unteransprüchen zu entnehmen.

Es ist darauf hinzuweisen, dass selbstverständlich jeder Stromleiter entsprechend mit Ausnehmungen oder Eintiefungen bzw. Bereichen geringerer Leitfähigkeit versehen wird, sofern an der jeweiligen Schaltungsanordnung mehrere Stromleiter vorgesehen sind.

Insgesamt ist es mit der vorliegenden Erfindung möglich, ein von einem stromdurchflossenen Leiter erzeugtes Feld, beispielsweise ein Schreibfeld im Falle des MRAMs ohne wesentlichen technologischen Aufwand zu homogenisieren. Die Packungsdichte wird hierbei nicht beeinflusst. Im Falle des MRAMs wird auch das Auslesen einer Zelle nicht beeinflusst, da oberhalb der von der Ausnehmung bzw. dem Bereich erhöhter Leitfähigkeit gebildeten Barriere noch metallisches Material liegt, das eine Äquipotentialfläche darstellt, für den Stromfluss in der Schichtebene aber hochohmig ist.

Weitere Vorteile, Merkmale und Einzelheiten der Erfindung ergeben sich aus den im Folgenden beschriebenen Ausführungsbeispielen sowie anhand der Zeichnungen. Dabei zeigen:
- Fig. 1: eine Prinzipskizze der Stromleiterführung bei einem MRAM,
- Fig. 2: einen Schnitt durch einen Kreuzungspunkt der in Fig. 1 gezeigten Konfiguration,
- Fig. 3: eine Darstellung des Magnetfeldverlaufs eines Stromleiters mit und ohne erfindungsgemäßer Strukturierung,
- Fig. 4: Prinzipskizzen zur Darstellung der Herstellung eines strukturierten Stromleiters gemäß einem ersten Verfahren,
- Fig. 5: Prinzipskizzen zur Darstellung der Herstellung eines strukturierten Stromleiters gemäß einer zweiten Verfahrensvariante,
- Fig. 6: Prinzipskizzen zur Darstellung der Herstellung eines strukturierten Stromleiters gemäß einer dritten Verfahrensvariante,
- Fig. 7: Prinzipskizzen zur Darstellung der Herstellung eines strukturierten Stromleiters gemäß einer vierten Verfahrensvariante,
- Fig. 8: Prinzipskizzen zur Darstellung der Herstellung eines strukturierten Stromleiters gemäß einer fünften Verfahrensvariante,
- Fig. 9: Prinzipskizzen zur Darstellung der Herstellung eines strukturierten Stromleiters gemäß einer sechsten Verfahrensvariante, und
- Fig. 10: Prinzipskizzen zur Darstellung der Herstellung eines strukturierten Stromleiters gemäß einer siebten Verfahrensvariante.

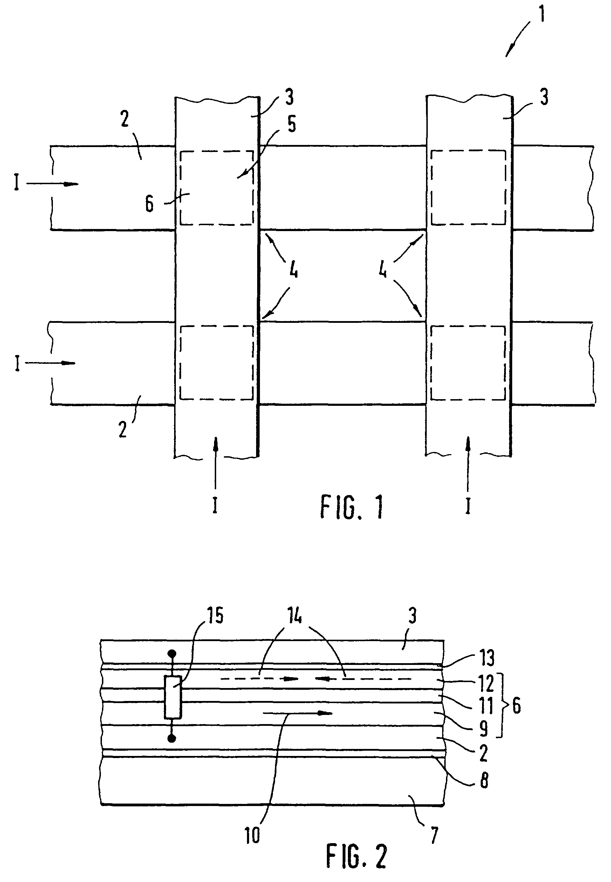

Fig. 1 zeigt als Prinzipskizze eine Schaltungsanordnung 1, die auf einem nicht näher gezeigten Substrat ausgebildet ist. Diese Schaltungsanordnung 1 umfasst erste Stromleiter 2, die in einer ersten, unteren Ebene parallel zueinander verlaufen, sowie zweite Stromleiter 3, die in einer zweiten, darüber liegenden Ebene ebenfalls parallel zueinander verlaufen. Die Stromleiter 2 und 3 selbst verlaufen rechtwinklig zueinander. An den jeweiligen Kreuzungspunkten 4 ist zwischen den Stromleitern 2, 3 jeweils ein weiteres Teil 5 in Form eines magnetischen Schichtsystems 6 angeordnet, das in der Prinzipskizze rechteckig gezeigt ist, in der Praxis aber wird es rundlich oder linsenförmig ausgebildet, was hinsichtlich der sehr schnell erfolgenden Magnetisierungsänderung von Vorteil ist, da sich die Magnetisierung leichter drehen kann. Dieses Schichtsystem 6 kann mit einem von den stromdurchflossenen Stromleitern 2, 3 erzeugten Magnetfeld beaufschlagt werden. Zu diesem Zweck sind die Stromleiter 2, 3 bestrombar, wie durch die Pfeile I angegeben ist. Die Funktionsweise eines solchen in Fig. 1 gezeigten MRAMs ist nun derart, dass jeder Stromleiter mit dem halben zum Umschalten der Speicherschichtmagnetisierung (hierauf wird nachfolgend bezüglich Fig. 2 noch eingegangen) erforderlichen Strom beaufschlagt wird. Die bestromten Leiter 2, 3 treffen sich in einem bestimmten Kreuzungspunkt 4, wo die beiden vom jeweils halben Strom erzeugten Magnetfelder sich einander überlagern und insgesamt an dem Schichtsystem 6 ein hinreichend hohes Magnetfeld anliegt, so dass die Speicherschichtmagnetisierung umgeschalten werden kann. Dieses Ummagnetisieren geht mittels eines Drehvorgangs der Magnetisierung vonstatten, weshalb es auf ein bestimmtes Timing des Einschaltens der einzelnen Ströme und damit des Erzeugens der einzelnen Magnetfelder, die in einer Richtung senkrecht zueinander gerichtet sind, ankommt. Die prinzipielle Funktionsweise eines MRAMs ist hinreichend bekannt, weshalb hierauf näher nicht mehr eingegangen werden muss.

Dies hat den besonderen Vorteil, dass ferner die sich aus der Überlagerung zweier Felder mit deutlich ausgeprägtem Maxima ergebende Schwierigkeiten vermieden werden. Denn aufgrund dieser bei unstruktierten Leitern gegebenen Feldausprägung sind die auf die Magnetisierung der Speicherschicht wirkenden Kraftvektoren des Überlagerungsfeldes über die Fläche, über welche das Feld auf die Speicherschicht einwirkt, nicht weitestgehend gleichmäßig gerichtet, sondern verlaufen teilweise unter einem beachtlichen Winkel zueinander. Hintergrund ist, dass die Felder der Stromleiter 2, 3 senkrecht zueinander stehen. Aufgrund der Feldüberlagerung mit stark ausgeprägtem Maximum ergibt sich lediglich in der Mitte der Feldwirkfläche eine gleichmäßige Feldverteilung, das heißt, der resultierende Kraftvektor steht unter 45° bezüglich der beiden Einzelfelder. Außerhalb der Mitte ist der jeweilige Feldbeitrag zum resultierenden Kraftvektor unterschiedlich groß, was dazu führt, dass der jeweilige Kraftvektor aus der 45°-Stellung leicht verkippt. Dieser Verkippungswinkel beträgt mehrere Grad. Dies führt nun dazu, dass nicht nur die gesamte Feldstärke über die Einwirkfläche inhomogen ist, sondern auch die Richtung, in welcher das Schreibfeld auf die Magnetisierung der Speicherschicht einwirkt. Dies kann im Extremfall dazu führen, dass die Magnetisierung der Speicherschicht in Einzeldomänen zerfallen kann.

Werden demgegenüber zwei über einen großen Bereich der Einwirk- und Überlagerungsfläche homogene Einzelfelder überlagert, so ist zum einen die Feldstärke über die Überdeckungsfläche, also die Fläche des Speicherschichtsystems, die mit dem Überlagerungsfeld belegt wird, möglichst homogen, ferner ist die Kraftrichtung auch weitgehend einheitlich.

Fig. 2 zeigt als Prinzipskizze einen Schnitt durch einen Kreuzungspunkt. Gezeigt ist ein glatter Untergrund, z.B. das Substrat 7, als welches bevorzugt ein Siliziumwafer verwendet wird. Alternativ können auch mehrere identische MRAM-Zellanordnungen übereinander geschichtet sein. Auf diesem Substrat ist unter Zwischenschaltung einer Isolationsschicht 8 (z. B. SiO₂) der erste untere Stromleiter 2 mit einer Diffusionssperre 13 aufgebracht. Auf diesen ist das Speicherschichtsystem 6 als Dünnschicht-Multilayerstruktur aufgebracht. Zunächst wird eine Referenzschicht 9 abgeschieden. Diese Referenzschicht 9 zeigt eine permanente Magnetisierung 10, die in einer ersten Richtung ausgerichtet ist. Die Referenzschicht selbst besteht aus einer Dünnschicht-Multilayerstruktur mit einer ersten Schicht aus Co-Fe, einer Schicht aus Ru und einer Schicht aus Co-Fe, wobei die Schichtdicken im Bereich von ca. einem nm liegen.

Auf die Referenzschicht 9 wird eine Tunnelbarrierenschicht 11 aufgebracht, bei der es sich bevorzugt um eine Schicht aus Al₂O₃ handelt. Auf diese Tunnelbarrierenschicht 11 wird wiederum die eigentliche Speicherschicht 12 abgeschieden, die bevorzugt aus Permaloy (NiFe 80:20) besteht. Die Schichten 9, 11 und 12 bilden das Schichtsystem 6.

Schließlich wird auf das Schichtsystem 6 eine Diffusionssperre 13, bevorzugt aus Ta5 abgeschieden, die verhindert, dass ungewünschte Elemente in das Schichtsystem 6 eindiffundieren und dieses beeinträchtigen. Darauf wird der obere Stromleiter 3 ausgebildet. Das gesamte Schichtsystem 6 kann ebenso auch in umgekehrter Reihenfolge aufgebracht werden. Die Referenzschicht liegt dann oberhalb der Barriere.

Ersichtlich besitzt die Speicherschicht 12 eine Magnetisierung 14, die wie durch die beiden gestrichelten, gegeneinander weisenden Pfeile in die eine oder andere Richtung ausgerichtet werden kann. Dies erfolgt wie beschrieben durch entsprechendes getaktetes Bestromen der Stromleiter 2 und 3. Nach Abstellen des Magnetfelds verbleibt die Magnetisierung 14 in der eingestellten Richtung. Sie kann entweder parallel oder entgegengesetzt zur Magnetisierung 10 der Referenzschicht liegen. Hierüber wird der Innenwiderstand über die gezeigte Struktur, der durch das Symbol 15 dargestellt ist, beeinflusst. Liegen die beiden Magnetisierungen parallel, ist der Innenwiderstand niedrig, liegen sie einander entgegengesetzt ist der Innenwiderstand deutlich höher. Wird nun ein Strom über die gezeigte Struktur geführt, so ändert sich abhängig von der Magnetisierungsstellung das erhaltene Signal. Hierüber ist es möglich, in die in Fig. 2 gezeigte MRAM-Speicherzelle eine Information in Form von "0" und "1" einzuschreiben und sie zu einem beliebigen späteren Zeitpunkt auszulesen. Die Information bleibt gespeichert.

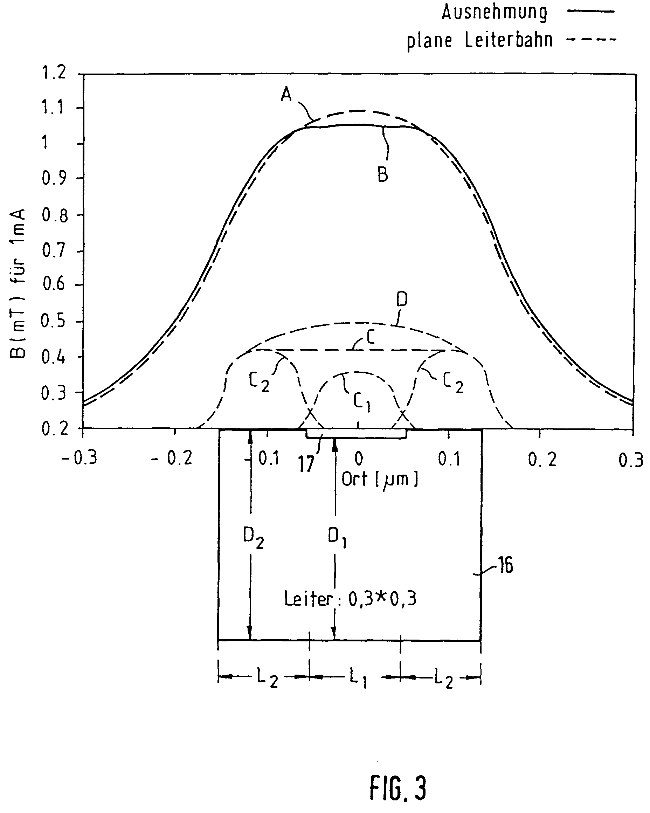

Fig. 3 zeigt als Prinzipskizze im oberen Teil den Verlauf des Magnetfelds des unterhalb des Diagramms gezeigten Stromleiters. Der Stromleiter ist im Wesentlichen quadratisch ausgebildet mit einem Leiterquerschnitt von z.B. 0,3 x 0,3 µm. Am Stromleiter 16 ist oberseitig eine Ausnehmung 17 vorgesehen, die im gezeigten Beispiel 0,1 µm breit und 10 nm tief ist. Wird nun der Stromleiter 16 mit Strom beaufschlagt so bildet sich ein Magnetfeld aus. In der darüber stehenden Graphik ist der Feldverlauf für den Stromleiter 16 ohne und mit Ausnehmung dargestellt. Die gestrichelte Kurve A zeigt den Verlauf ohne Ausnehmung. Ersichtlich zeigt die Kurve A einen glockenförmigen Verlauf mit einem ausgeprägten Feldmaximum. Demgegenüber zeigt die ausgezogene Kurve B, die den Verlauf mit Ausnehmung darstellt, eine deutliche Einebnung und Homogenisierung des Felds im Bereich des Maximums. Dies wird durch die aufgrund der Ausnehmung reduzierte Dicke erreicht. Wie Fig. 3 zeigt ist der Durchmesser im Abschnitt L1 durch die Ausnehmung auf D1 reduziert gegenüber dem Durchmesser D2 in den angrenzenden Abschnitten L2. Näherungsweise kann jeder der Abschnitte L1 und L2 als separater Leiter betrachtet werden, über dem sich, wie in Fig. 3 separat und gestrichelt dargestellt ist, ein eigenes Magnetfeld C₁, C₂ aufbaut. Ersichtlich ist das Magnetfeld C₁ im Abschnitt L1 etwas schwächer, da aufgrund der Verschiebung des Stromdichtezentrums infolge der Durchmesserverringerung aus der Leitermitte nach unten zu einer anderen Stromdichteverteilung im Leiter führt. Durch Überlagerung der näherungsweise erzeugten gestrichelt dargestellten Einzelfelder C₁, C₂ zur ebenfalls gestrichelt dargestellten Gesamtkurve C wird ersichtlich, dass sich das Strommaximum auf diese Weise einebnen lässt. Die Kurve D zeigt demgegenüber das "Gesamtfeld" des Leiters ohne Ausnehmung.

Übertragen auf den Fall des vorbeschriebenen MRAMs bedeutet dies nun, dass es durch entsprechende Ausbildung der Stromleiter 2, 3 möglich ist, den Feldverlauf gezielt zu beeinflussen und eine Homogenisierung herbeizuführen. Allgemein bedeutet dies, dass es durch entsprechende Ausbildung des Stromleiterquerschnitts möglich ist, den Feldverlauf zu designen.

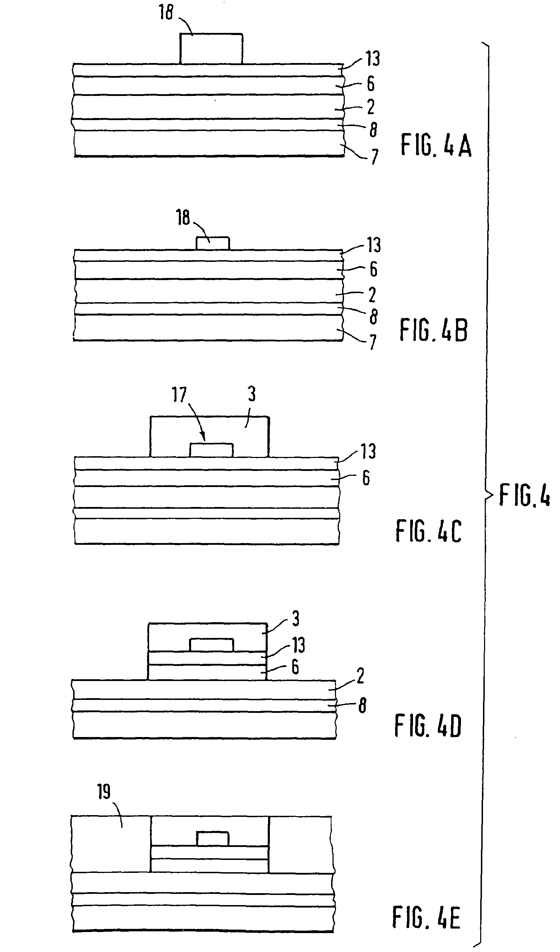

Fig. 4 zeigt als erste Verfahrensvariante, wie ein solcher mit einer Ausnehmung versehener oberer Stromleiter erzeugt werden kann. Im gezeigten Beispiel ist ein Substrat 7, die Isolationsschicht 8 sowie der untere Stromleiter 2 gezeigt, auf dem wiederum das Schichtsystem 6 vorgesehen ist, das mit einer Diffusionssperre 13 abgedeckt ist. Alternativ kann die Diffusionssperre 13 auch auf dem Stromleiter 2 angeordnet sein. Auf die Diffusionssperre 13 wird im ersten Verfahrensschritt (Fig. 4A) eine Schicht 18 aus nichtleitendem Material aufgebracht. Bei diesem Material kann es sich beispielsweise um einen photolithographisch abscheidbaren Photolack handeln (verwendbar ist ein Positiv- oder ein Negativlack), alternativ kann auch ein nichtleitendes abscheidbares Metall, wie beispielsweise die hochohmige Phase von Tantal oder ein nichtleitender Antiferromagnet (NiO₂ oder ähnlich) verwendet werden.

Im nächsten Schritt (Fig. 4B) wird die Breite und Dicke der Schicht 18 auf vorbestimmte Maße reduziert, was durch geeignetes Veraschen des Lacks oder beispielsweise isotropes Abätzen oder Absputtern des aufgebrachten Metalls erfolgt. Die verbleibende Schicht 18 wird so dimensioniert, wie die in Fig. 3 gezeigte Ausnehmung 17 dimensioniert werden soll. Die Schicht 18 wird anschließend (Fig. 4C) vollständig mit dem Material des oberen Stromleiters 3 abgedeckt. Ersichtlich ändert sich aufgrund des Vorhandenseins der Schicht 18 über die Breite des Leiters 3 gesehen der Querschnitt (vgl. Fig. 3). Anschließend werden in einem Ätzprozess (Fig. 4D) die Diffusionssperre 13 und das Schichtsystem 6 in den Bereichen außerhalb des Leiters 3 abgeätzt, wonach im Schritt gem. Fig. 4E eine Isolationsschicht 19 (z. B. SiO₂)aufgebracht wird.

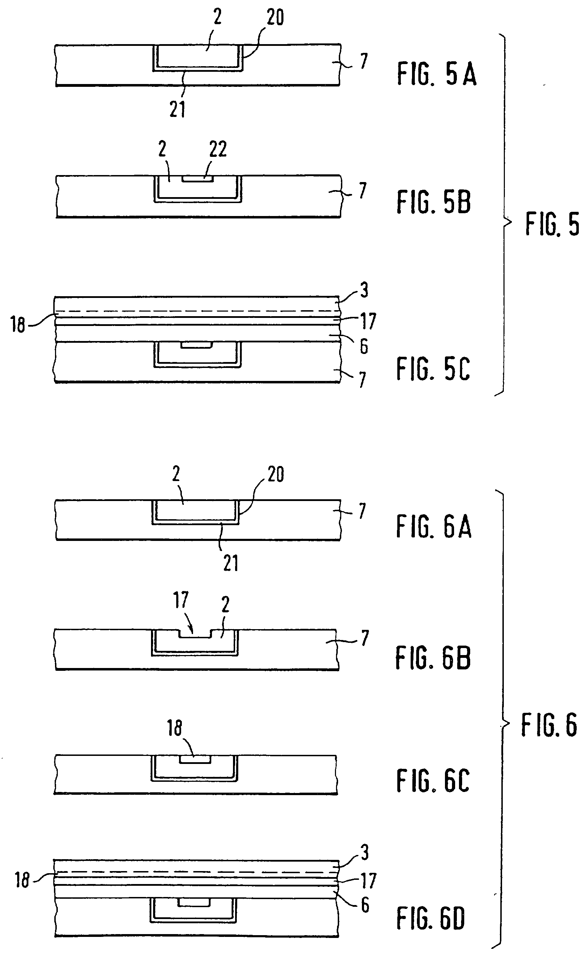

Eine zweite Verfahrensvariante zur erfindungsgemäßen Ausbildung des unteren Leiters zeigt Fig. 5. In das Substrat 7 wird zunächst eine Leiterbahnausnehmung 20 eingebracht, die innen mit einer Isolationsschicht 21 (z. B. SiO₂)belegt wird. In diese Ausnehmung wird anschließend der Leiter 2 eingebracht. Als Leitermaterial wird generell bevorzugt CMP-Kupfer verwendet. Anschließend wird an der freien Seite des Stromleiters 2 ein Bereich 22, der eine deutlich niedrigere Leitfähigkeit und damit einen höheren Widerstand aufweist als das übliche Leitergebiet durch gezielten Ionenbeschuss oder ein gezieltes Diffusionsverfahren ausgebildet. Auf die in Fig. 5b gezeigte Konfiguration wird anschließend in Dünnschichttechnologie das Schichtsystem 6, die Diffusionssperre 17 sowie der obere Leiter 3 mit der die Ausnehmung erzeugenden Schicht 18 ausgebildet, wie dies bezüglich der Fig. 4 beschrieben wurde.

Bei dieser Erfindungsausgestaltung ist also sowohl der untere als auch der obere Leiter erfindungsgemäß strukturiert. Es ist hier möglich, die Feldmaxima sowohl des vom unteren als auch des vom oberen Leiter erzeugten Feldes einzuebnen und zu homogenisieren.

Fig. 6 zeigt schließlich eine weitere Möglichkeit zur Strukturierung des unteren Leiters. Auch dort ist am Substrat 7 eine Leiterausnehmung 20 mit innerer Isolierung 21 vorgesehen. Am eingebrachten Stromleiter 2 wird nun durch Sputtern eines Ausnehmung 17 ausgebildet (Fig. 6B), in die (Fig. 6C) eine Schicht 18 eines Lacks bzw. eines nichtleitenden Metalls eingebracht wird. Anschließend wird das Schichtsystem 6, die Diffusionssperre 17 sowie der obere Leiter 3, der auch hier mit einer Schicht 18 strukturiert ist, aufgebracht.

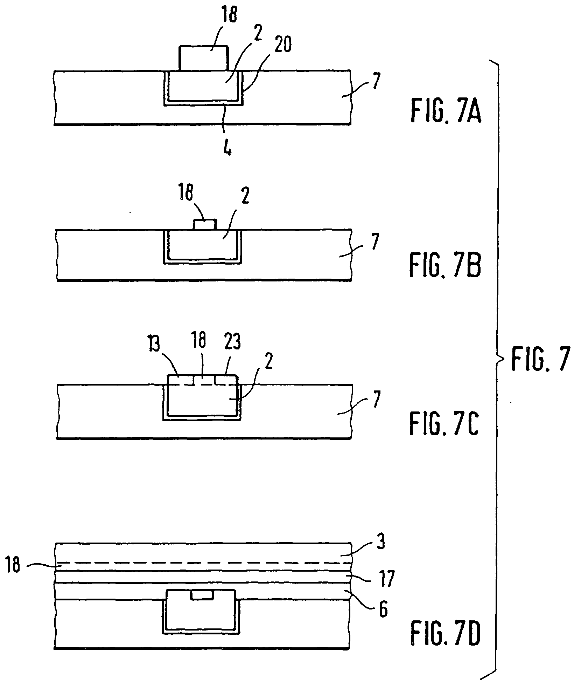

Schließlich zeigt Fig. 7 eine weitere Herstellungsvariante. Auf ein Substrat 7 wird in einer Leiterausnehmung 20 mit Isolation 21 der untere Stromleiter 2 eingebracht. Auf diesen wird eine größerflächige Schicht 18 (Lack oder Metall) aufgebracht (Fig. 7A), die (Fig. 7B) durch Abtragen auf die gewünschte Größe dimensioniert wird. Die Größe der Schicht 18 ist auch hier ausschlaggebend für die Größe der gebildeten Ausnehmung. Anschließend werden (Fig. 7C) beidseitig neben die Materialschicht 18 zwei Abschnitte 23 aus Leitermaterial gebracht, die die Schicht 18 zwischen sich aufnehmen. Diese sind in der Höhe so bemessen, dass sie möglichst eben mit der Schicht 18 oberseitig verlaufen. Insgesamt bildet sich also auch hier ein Leiter mit einer erfindungsgemäßen Ausnehmung bzw. entsprechenden Dickenstrukturierung. Anschließend wird (Fig. 7D) das Schichtsystem 6, die Diffusionssperre 17 sowie der obere Leiter 3 nebst Lack- oder Metallschicht 18 aufgebracht.

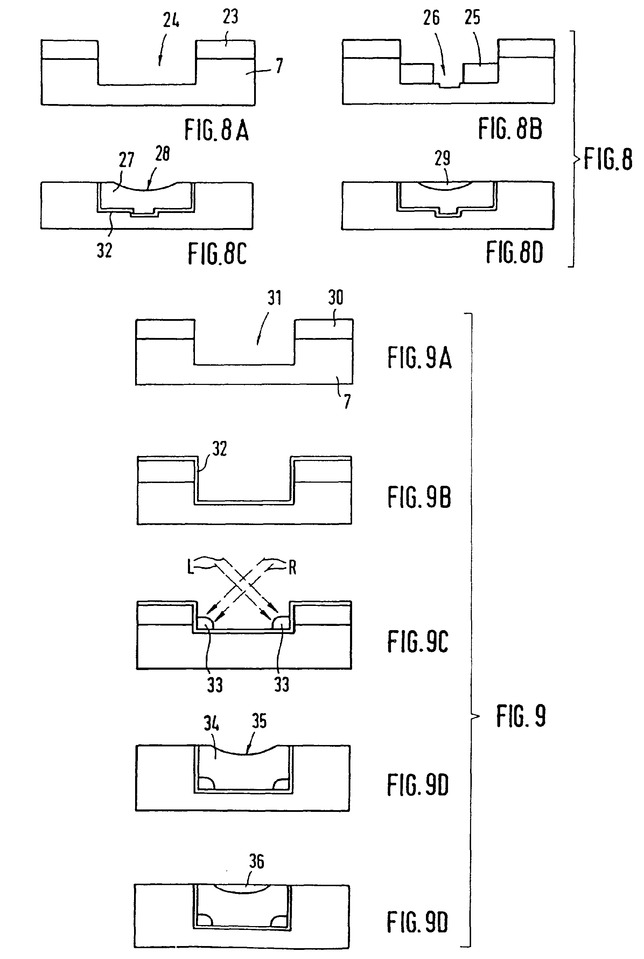

Fig. 8 zeigt eine weitere Verfahrensvariante in Form mehrerer Prinzipdarstellungen. Auf das Substrat 7 - bei dem es sich wie bei allen Ausführungsbeispielen entweder um Silizium oder aber auch um SiO₂ handeln kann - wird zunächst eine Lackschicht 23 aufgebracht, wonach ein erster Graben 24 in das Substrat 7 geätzt wird (Fig. 8A). Anschließend wird eine Lackschicht 25 im Graben 24 abgeschieden, die das Ätzen eines weiteren Grabens 26 zulässt (Fig. 8B). Insgesamt ergibt sich damit ein grabenförmiges Stufenprofil.

Nach Entfernern zumindest der Lackschicht 25 (die Lackschicht 23 kann zur weiteren Maskierung beibehalten werden) werden die Gräben 24, 26 mit dem Material 27 des Stromleiters verfüllt. Der Graben 26 bildet sich an der Oberseite des Stromleiters in Form der Ausnehmung oder Eintiefung 28 ab (Fig. 8C). Anschließend wird diese Ausnehmung oder Eintiefung 28 noch mit einem Material 29, z.B. einem Lack verfüllt. Nachfolgend werden wieder die weiteren Schichtelemente auf diese Struktur aufgebracht.

Fig. 9 zeigt eine weitere Verfahrensvariante. In ein Substrat 7 wird hier zunächst unter Verwendung einer Lackschicht 30 zur Maskierung ein Graben 31 eingeätzt, wonach - wie auch im Fall der Verfahrensvariante nach Fig. 8 - eine Diffusionssperre 32 in den Graben abgeschieden wird. Anschließend wird durch richtungsselektives Aufsputtern (wie durch die gestrichelten Pfeile L, R dargestellt) in die Grabenkante eine Erhebung 33 eingebracht. Dies erfolgt zweckmäßigerweise durch Aufsputtern eines Isolators wie z.B. SiO₂. Anschließend wird das Material 34 des Stromleiters eingebracht, wobei sich die zwischen den Erhebungen 33 verbleibende Vertiefung oberseitig wiederum abzeichnet, es bildet sich an der Leiteroberseite eine Ausnehmung oder eine Eintiefung 35. Diese wird (siehe Fig. 9E) anschließend wieder mit einem nichtleitenden Material 36, z.B. einem Lack verfüllt. Auch auf dieser Struktur werden anschließend die weiteren relevanten Schichten und Strukturen aufgebracht.

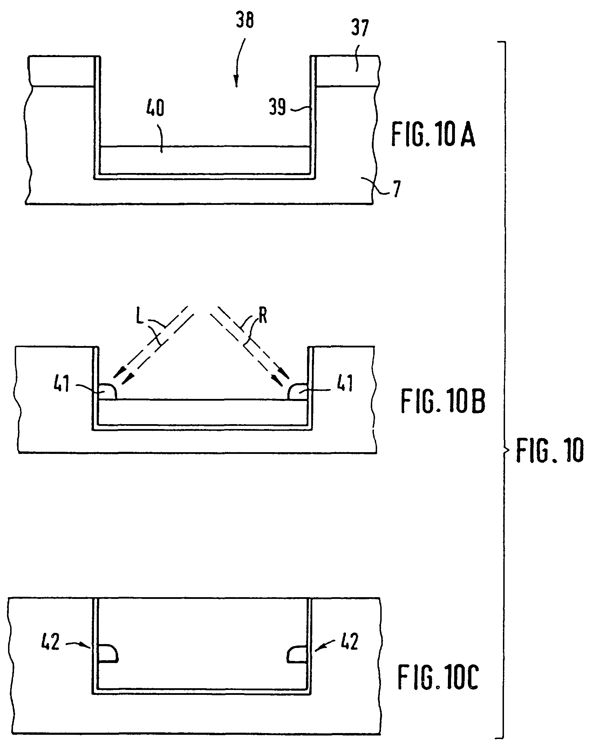

Eine letzte Verfahrensvariante zeigt Fig. 10. Bei dieser Verfahrensvariante wird ein Stromleiter hergestellt, dessen Seitenflächen in ihrer Oberflächenstruktur besonders ausgebildet sind. Im Schritt 10A wird zunächst unter Verwendung einer Lackschicht 37 ein Graben 38 in das Substrat 7 geätzt, wonach eine Diffusionssperre 39 aufgebracht wird. In den Graben 38 wird anschließend eine erste Schicht 40 aus Stromleitermaterial eingebracht. Auf diese Schichten werden, siehe Fig. 10B, durch richtungsselektives Aufsputtern (siehe die dort gestrichelten Pfeile L, R) wiederum zwei Erhebungen 41 in den Längskantenbereich eingebracht. Anschließend wird, siehe Schritt 10C, der restliche Graben verfüllt, so dass insgesamt ein Stromleiter erzeugt wird, dessen Seitenwände mit den Ausnehmungen oder Eintiefungen versehen werden. Diesen Seitenwänden gegenüberliegend kann ein weiteres Teil, z.B. ein Hall-Sensor zugeordnet werden, auf den das Magnetfeld des stromdurchflossenen Leiters einwirkt. Dieses Magnetfeld kann durch die Strukturierung der Oberfläche der jeweiligen Seite 42 wie beschrieben beeinflusst und "zurechtgeschneidert" werden.

Die gezeigten Ausführungsbeispiele sind nicht begrenzend. Es sind auch andere Verfahrensvarianten verwendbar, die die Strukturierung eines oder beider Stromleiter im erfindungsgemäßen Sinn zulassen.

Bezugszeichenliste
- 1: Schaltanordnung
- 2: Stromleiter
- 3: Stromleiter
- 4: Kreuzungspunkte
- 5: Teil
- 6: magnetisches Schichtsystem
- 7: Substrat
- 8: Isolationsschicht
- 9: Referenzschicht
- 10: Magnetisierung
- 11: Tunnelbarrierenschicht
- 12: Speicherschicht
- 13: Diffusionssperre
- 14: Magnetisierung
- 15: Symbol
- 16: Stromleiter
- 17: Diffusionssperre
- 18: Schicht
- 19: Isolationsschicht
- 20: Leiterbahnausnehmung
- 21: Isolationsschicht
- 22: Bereich
- 23: Lackschicht
- 24: Graben
- 25: Lackschicht
- 26: Graben
- 27: Material
- 28: Eintiefung
- 29: Material
- 30: Lackschicht
- 31: Graben
- 32: Diffusionssperre
- 33: Erhebung
- 34: Material
- 35: Eintiefung
- 36: Material
- 37: Lackschicht
- 38: Graben
- 39: Diffusionssperre
- 40: Schicht
- 41: Erhebung
- 42: Seite

- I: Pfeil
- A: Kurve
- B: Kurve
- L: Pfeil
- L1: Abschnitt
- L2: Abschnitt
- D1: Durchmeser
- D2: Durchmesser
- R: Pfeil

## Patentansprüche

1. Integrierte Schaltungsanordnung mit mindestens einem Stromleiter, der im stromdurchflossenen Zustand ein Magnetfeld erzeugt, das auf wenigstens ein weiteres Teil der Schaltungsanordnung einwirkt, **dadurch gekennzeichnet, dass** zur Beeinflussung des erzeugbaren Magnetfelds der Stromleiter (2, 3, 16) querschnittlich gesehen wenigstens eine Ausnehmung (17) oder Eintiefung oder einen Bereich (22) niedrigerer Leitfähigkeit an der dem Teil zugewandten Seite aufweist.

2. Integrierte Schaltungsanordnung nach Anspruch 1,
**dadurch gekennzeichnet, dass** ein Stromleiter (2, 3, 16) und ein weiteres zu diesem benachbartes Teil vorgesehen ist.

3. Integrierte Schaltungsanordnung nach Anspruch 1,
**dadurch gekennzeichnet, dass** mehrere in zwei Ebenen liegende und sich im Wesentlichen rechtwinklig kreuzende Stromleiter (2, 3) vorgesehen sind, zwischen denen an jeweils einem Kreuzungspunkt (4) ein weiteres Teil (6) aufgenommen ist.

4. Integrierte Schaltungsanordnung nach Anspruch 3,
**dadurch gekennzeichnet, dass** nur einer der sich in einem Kreuzungspunkt (4) kreuzenden Stromleiter (2, 3) eine Ausnehmung (17) oder Eintiefung oder einen Bereich (22) niedrigerer Leitfähigkeit aufweist.

5. Integrierte Schaltungsanordnung nach Anspruch 3,
**dadurch gekennzeichnet, dass** beide sich in einem Kreuzungspunkt (4) kreuzenden Stromleiter (2, 3) eine Ausnehmung (17) oder Eintiefung oder einen Bereich niedrigerer Leitfähigkeit aufweisen.

6. Integrierte Schaltungsanordnung nach einem der vorangehenden Ansprüche, **dadurch gekennzeichnet, dass** sich die Ausnehmung (17) oder Eintiefung oder der Bereich niedrigerer Leitfähigkeit verringerter Leiterdicke über einen wesentlichen Teil der Länge des oder eines Stromleiters (2, 3) erstreckt, oder dass sie nur im Wesentlichen punktuell im Bereich der Kreuzungspunkte (4) an dem oder beiden Stromleitern (2, 3) vorgesehen ist.

7. Integrierte Schaltungsanordnung nach einem der vorangehenden Ansprüche, **dadurch gekennzeichnet, dass** die Ausnehmung (17) oder Eintiefung einen im Wesentlichen rechteckigen Querschnitt aufweist.

8. Integrierte Schaltungsanordnung nach einem der Ansprüche 1 bis 6, **dadurch gekennzeichnet, dass** die Ausnehmung (17) oder Eintiefung einen im Wesentlichen konkaven Querschnitt aufweist.

9. Integrierte Schaltungsanordnung nach einem der Ansprüche 7 oder 8, **dadurch gekennzeichnet, dass** die Ausnehmung (17) oder Eintiefung mit einem nichtleitenden Material (18) gefüllt ist.

10. Integrierte Schaltungsanordnung nach Anspruch 9,
**dadurch gekennzeichnet, dass** das Material (18) ein Lack oder ein nichtleitendes Metall, insbesondere die hochohmige Phase von Tantal oder ein nichtleitender natürlicher Antiferromagnet zur magnetischen Stabilisierung eines artifiziellen Antiferromagneten ist.

11. Integrierte Schaltungsanordnung nach einem der vorangehenden Ansprüche, **dadurch gekennzeichnet, dass** der Bereich (22) durch Ionenbeschuß oder durch Diffusion in seiner Leitfähigkeit erniedrigt ist.

12. Integrierte Schaltungsanordnung nach einem der vorangehenden Ansprüche, **dadurch gekennzeichnet, dass** der Bereich der Ausnehmung (17) oder Eintiefung bzw. der Bereich (22) niedrigerer Leitfähigkeit im Wesentlichen mittig oder außermittig am Stromleiter (2, 3) bezogen auf seine Breite vorgesehen ist.

13. Integrierte Schaltungsanordnung nach einem der vorangehenden Ansprüche, **dadurch gekennzeichnet, dass** an der gegenüberliegenden Seite des Stromleiters randseitig Ausnehmungen oder Eintiefungen oder Bereiche niedrigerer Leitfähigkeit zur Reduktion der Leiterdicke vorgesehen sind, die bezüglich der gegenüberliegenden Anordnung oder Eintiefung oder dem Bereich versetzt angeordnet sind.

14. Verfahren zur Herstellung einer integrierten Schaltungsanordnung mit einem oder mehreren in einer Ebene liegenden Stromleitern, bei welchem Verfahren nach Erzeugung des weiteren Teils in Form einer durch ein Magnetfeld beeinflussbaren Schicht folgende Schritte durchgeführt werden:
- Erzeugen einer Schicht aus nichtleitendem Material entsprechend der Lage einer nachfolgend zu erzeugenden Stromleiters,
- Reduzieren der Dicke und/oder Breite der Materialschicht,
- Aufbringen eines die Materialschicht überdeckenden Stromleiters.

15. Verfahren nach Anspruch 14, **dadurch gekennzeichnet, dass** als Material ein Lack verwendet wird, der vor der Reduktion belichtet und entwickelt wird.

16. Verfahren nach Anspruch 15, **dadurch gekennzeichnet, dass** der Lack zur Reduktion verascht wird.

17. Verfahren nach Anspruch 14, **dadurch gekennzeichnet, dass** als Material ein nichtleitendes Metall, insbesondere die nichtleitende Phase von Tantal oder ein nichtleitender natürlicher Antiferromagnet verwendet wird.

18. Verfahren nach Anspruch 17, **dadurch gekennzeichnet, dass** das nichtleitende Metall oder der Antiferromagnet zur Reduktion geätzt wird.

19. Verfahren zur Herstellung einer integrierten Schaltungsanordnung mit einem oder mehreren in einer Ebene liegenden Stromleitern, bei welchem Verfahren vor der Erzeugung des weiteren Teils in Form einer durch ein Magnetfeld beeinflussbaren Schicht folgende Schritte durchgeführt werden:
- Erzeugen eines oder mehrerer Stromleiter auf einem Substrat,
- Erzeugen eines Bereichs niedrigerer Leitfähigkeit an der freien Seite eines Stromleiters zur Reduktion der für die Ausbildung eines Magnetfeld bei Stromfluss relevanten Leiterdicke,
wonach die veränderbare Schicht auf einem Stromleiter erzeugt wird.

20. Verfahren nach Anspruch 19, **dadurch gekennzeichnet, dass** der Bereich niedrigerer Leitfähigkeit durch Ionenbeschuß eines Stromleiters erzeugt wird.

21. Verfahren nach Anspruch 19, **dadurch gekennzeichnet, dass** der Bereich niedrigerer Leitfähigkeit durch Diffusion wenigstens eines die Leitfähigkeit erniedrigenden Elements in den Stromleiter erzeugt wird.

22. Verfahren nach einem der Ansprüche 19 bis 21, **dadurch gekennzeichnet, dass** nach Erzeugung der veränderbaren Schicht ein oder mehrere weitere über der Schicht liegende Stromleiter nach dem Verfahren nach einem der Ansprüche 14 bis 18 erzeugt werden.

23. Verfahren zur Herstellung einer integrierten Schaltungsanordnung mit einem oder mehreren in einer Ebene liegenden Stromleitern, bei welchem Verfahren vor der Erzeugung des weiteren Teils in Form einer durch ein Magnetfeld beeinflussbaren Schicht folgende Schritte durchgeführt werden:
- Erzeugen eines oder mehrerer Stromleiter auf einem Substrat,
- Erzeugen einer Ausnehmung oder einer Eintiefung an der freien Seite eines Stromleiters zur Reduktion der für die Ausbildung eines Magnetfelds bei Stromfluss relevanten Leiterdicke,
- Einbringen eines nichtleitenden Materials in die Ausnehmung oder Eintiefung,
wonach die veränderbare Schicht auf einem Stromleiter erzeugt wird.

24. Verfahren nach Anspruch 23, **dadurch gekennzeichnet, dass** die Ausnehmung oder Eintiefung in einem Sputterverfahren ausgebildet wird.

25. Verfahren nach Anspruch 23 oder 24, **dadurch gekennzeichnet, dass** als Material ein Lack verwendet wird, der nach dem Einbringen belichtet und entwickelt wird.

26. Verfahren nach Anspruch 23 oder 24, **dadurch gekennzeichnet, dass** als Material ein nichtleitendes Metall, insbesondere die nichtleitende Phase von Tantal oder ein nichtleitender natürlicher Antiferromagnet verwendet wird.

27. Verfahren nach einem der Ansprüche 23 bis 26, **dadurch gekennzeichnet, dass** nach Erzeugung der veränderbaren Schicht ein oder mehrere weitere über der veränderbaren Schicht liegende Stromleiter nach dem Verfahren nach einem der Ansprüche 14 bis 18 erzeugt werden.

28. Verfahren zur Herstellung einer integrierten Schaltungsanordnung mit einem oder mehreren in einer Ebene liegenden Stromleitern, bei welchem Verfahren vor der Erzeugung des weiteren Teils in Form einer durch ein Magnetfeld beeinflussbaren Schicht folgende Schritte durchgeführt werden:
- Erzeugen eines oder mehrerer Stromleiter auf einem Substrat,
- Erzeugen einer Schicht aus nichtleitendem Material auf einem Stromleiter,
- Reduzieren der Dicke und/oder Breite der Materialschicht,
- Erzeugen weiterer die verbliebene Materialschicht seitlich umgebender Abschnitte des Stromleiters zur Bildung eines Stromleiters mit einer für die Ausbildung eines Magnetfeld bei Stromfluss reduzierten relevanten Leiterdicke,
wonach die veränderbare Schicht auf einem Stromleiter erzeugt wird.

29. Verfahren nach Anspruch 28, **dadurch gekennzeichnet, dass** als Material ein Lack verwendet wird, der vor der Reduktion belichtet und entwickelt wird.

30. Verfahren nach Anspruch 29, **dadurch gekennzeichnet, dass** der Lack zur Reduktion verascht wird.

31. Verfahren nach Anspruch 28, **dadurch gekennzeichnet, dass** als Material ein nichtleitendes Metall, insbesondere die nichtleitende Phase von Tantal oder ein nichtleitender natürlicher Antiferromagnet verwendet wird.

32. Verfahren nach Anspruch 31, **dadurch gekennzeichnet, dass** das nichtleitende Metall oder der Antiferromagnet zur Reduktion geätzt wird.

33. Verfahren nach einem der Ansprüche 28 bis 32, **dadurch gekennzeichnet, dass** nach Erzeugung der veränderbaren Schicht ein oder mehrere weitere über der veränderbaren Schicht liegende Stromleiter nach dem Verfahren nach einem der Ansprüche 14 bis 18 erzeugt werden.

34. Verfahren zur Herstellung einer integrierten Schaltungsanordnung mit einem oder mehreren in einer Ebene liegenden Stromleitern, bei welchem Verfahren vor der Erzeugung des weiteren Teils in Form einer durch ein Magnetfeld beeinflussbaren Schicht folgende Schritte durchgeführt werden:
- Erzeugen eines Grabens in einem Substrat,
- Erzeugen eines weiteren schmäleren Grabens am Boden des ersten Grabens,
- Erzeugen einer Diffusionssperre in den Gräben,
- Verfüllen der Gräben mit dem Material des Stromleiters, wobei sich oberseitig eine Ausnehmung oder Eintiefung als Folge des weiteren Grabens ausbildet,
- Einbringen eines nichtleitenden Materials in die an der Oberseite des Stromleiters ausgebildete Ausnehmung oder Eintiefung,
- wonach die veränderbare Schicht auf dem Stromleiter erzeugt wird.

35. Verfahren nach Anspruch 34, **dadurch gekennzeichnet, dass** als Material ein Lack, ein nichtleitendes Metall, insbesondere die nichtleitende Phase von Tantal oder ein nichtleitender natürlicher Antiferromagnet verwendet wird.

36. Verfahren nach Anspruch 34 oder 35, **dadurch gekennzeichnet, dass** nach Erzeugung der veränderbaren Schicht ein oder mehrere weitere über der veränderbaren Schicht liegende Stromleiter nach dem Verfahren nach einem der Ansprüche 14 bis 18 erzeugt werden.

37. Verfahren zur Herstellung einer integrierten Schaltungsanordnung mit einem oder mehreren in einer Ebene liegenden Stromleitung, bei welchem Verfahren vor der Erzeugung des weiteren Teils in Form einer durch einen Magnetfeld beeinflussbaren Schicht folgende Schritte durchgeführt werden:
- Erzeugen eines Grabens in einem Substrat,
- Erzeugen eines weiteren schmäleren Grabens am Boden des ersten Grabens,
- Einbringen einer Diffusionssperre in die Gräben,
- Verfüllen der Gräben mit dem Material des Stromleiters, wobei eine ebene Oberfläche des Stromleiters erhalten wird,
- Erzeugen einer Ausnehmung oder Eintiefung oder eines Bereichs geringer Leitfähigkeit an der Oberfläche des Stromleiters,
- gegebenenfalls Einbringen eines nichtleitenden Materials in die Ausnehmung oder Eintiefung,
- wonach die veränderbare Schicht auf dem Stromleiter erzeugt wird.

38. Verfahren nach Anspruch 37, **dadurch gekennzeichnet, dass** die Ausnehmung oder Eintiefung in einem Sputter-Verfahren ausgebildet wird.

39. Verfahren nach Anspruch 38, **dadurch gekennzeichnet, dass** als Material ein Lack, ein nichtleitendes Metall, insbesondere nichtleitende Phase von Tantal oder ein nichtleitender natürlicher Antiferromagnet verwendet wird.

40. Verfahren nach Anspruch 37, **dadurch gekennzeichnet, dass** der Bereich niedriger Leitfähigkeit durch Ionenbeschuss eines Stromleiters oder durch Diffusion wenigstens eines die Leitfähigkeit erniedrigenden Elements in den Stromleiter erzeugt wird.

41. Verfahren nach einem der Ansprüche 37 bis 40, **dadurch gekennzeichnet, dass** nach Erzeugen der veränderbaren Schicht ein oder mehrere weitere über der Schicht liegende Stromleiter nach dem Verfahren nach einem der Ansprüche 14 bis 18 erzeugt werden.

42. Verfahren zur Herstellung einer integrierten Schaltungsanordnung mit einem oder mehreren in einer Ebene liegenden Stromleitern, bei welchem Verfahren vor der Erzeugung des weiteren Teils in Form einer durch ein Magnetfeld beeinflussbaren Schicht folgende Schritte durchgeführt werden:
- Erzeugen eines Grabens in einem Substrat,
- Einbringen einer Diffusionsschicht in den Graben,
- Erzeugen von nichtleitenden Erhebungen in den Grabenkanten, so dass zwischen den Erhebungen eine Vertiefung verbleibt,
- Verfüllen des Grabens mit dem Material des Stromleiters,
wobei sich oberseitig eine Ausnehmung oder Eintiefung als Folge der zwischen den Erhebungen gebildeten Vertiefung ausbildet, oder derart, dass sich eine ebene Stromleiteroberfläche ergibt,
- bei gegebener ebener Stromleiteroberfläche Erzeugen einer Ausnehmung oder Eintiefung an der Stromleiteroberseite,
- Einbringen eines nichtleitenden Materials in die an der Oberseite des Stromleiters ausgebildete Ausnehmung oder Eintiefung,
- wonach die veränderbare Schicht auf den Stromleiter erzeugt wird.

43. Verfahren nach Anspruch 42, **dadurch gekennzeichnet, dass** die Erhebungen durch Aufsputtern eines Isolators, insbesondere von SiO₂ oder Si₃N₄ gebildet werden.

44. Verfahren nach Anspruch 43, **dadurch gekennzeichnet, dass** die Ausnehmung in der ebenen Stromleiteroberfläche in einem Sputterverfahren ausgebildet wird.

45. Verfahren nach einem der Ansprüche 42 bis 44, **dadurch gekennzeichnet, dass** als Material ein Lack, ein nichtleitendes Metall, insbesondere die nichtleitende Phase von Tantal oder ein nichtleitender natürlicher Antiferromagnet verwendet wird.

46. Verfahren nach einem der Ansprüche 42 bis 45, **dadurch gekennzeichnet, dass** nach der Erzeugung der veränderbaren Schicht ein oder mehrere weitere über der Schicht liegende Stromleiter nach dem Verfahren nach einem der Ansprüche 14 bis 18 erzeugt werden.

47. Verfahren zur Herstellung einer integrierten Schaltungsanordnung mit einem oder mehreren in einer Ebene liegenden Stromleitern, bei welchem Verfahren vor der Erzeugung des weiteren Teils in Form einer durch ein Magnetfeld beeinflussbaren Schicht folgende Schritte durchgeführt werden:
- Erzeugen eines Grabens in einem Substrat,
- Einbringen einer Diffusionssperre in den Graben,
- Einbringen einer ersten Materialschicht des Stromleiters,
- Erzeugen von nichtleitenden Erhebungen an den gegenüberliegenden Rändern der ersten Schicht, so dass zwischen den Erhebungen eine Vertiefung verbleibt,
- Verfüllen des restlichen Grabens mit Material des Stromleiters, so dass oberseitig eine ebene Stromleiterfläche verbleibt.

48. Verfahren nach Anspruch 47, **dadurch gekennzeichnet, dass** die Erhebungen durch Aufsputtern eines Isolators, insbesondere von SiO₂ oder Si₃N₄ erzeugt werden.
